(19) Europäisches Patentamt / European Patent Office / Office européen des brevets

(11) **EP 2 929 235 B1**

(12) **EUROPEAN PATENT SPECIFICATION**

(45) Date of publication and mention
of the grant of the patent:
**15.05.2019 Bulletin 2019/20**

(21) Application number: **12889618.0**

(22) Date of filing: **07.12.2012**

(51) Int Cl.:
*F21V 5/00* (2018.01)    *G02B 27/48* (2006.01)
*G08G 1/017* (2006.01)    *F21K 99/00* (2016.01)
*G08B 13/196* (2006.01)    *H01S 5/00* (2006.01)
*G02B 5/02* (2006.01)    *G02B 5/32* (2006.01)
*H04N 7/18* (2006.01)

(86) International application number:
**PCT/CA2012/050878**

(87) International publication number:
**WO 2014/085895 (12.06.2014 Gazette 2014/24)**

(54) **SURVEILLANCE IMAGING SYSTEM**

ÜBERWACHUNGSSYSTEM MIT BILDGEBUNG

SYSTEME DE SURVEILLANCE FORMANT UN IMAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**14.10.2015 Bulletin 2015/42**

(73) Proprietor: **Robert Bosch GmbH
70442 Stuttgart (DE)**

(72) Inventors:
• **NICHOLSON, Gary
Port Moody, British Columbia V3H 5A3 (CA)**

• **TSIBOULIA, Andrei
Burnaby, British Columbia V3J 1M1 (CA)**

(56) References cited:
EP-A2- 0 040 839          WO-A1-03/017193
WO-A1-2008/037049    WO-A1-2009/133111
WO-A1-2010/067282    WO-A1-2010/067282
WO-A1-2012/139634    JP-A- 2001 100 621
US-A- 6 081 381          US-A1- 2007 052 953
US-A1- 2008 079 904    US-A1- 2009 213 350
US-A1- 2010 103 676    US-A1- 2010 296 065
US-A1- 2011 032 587

**Description**

FIELD OF INVENTION

This invention relates to a surveillance imaging system comprising an illumination system, and more specifically to phase homogenization of coherent light from illuminators used for surveillance imaging systems.

BACKGROUND OF THE INVENTION

Surveillance imaging requires sufficient and evenly distributed on-scene illumination for adequate and timely target recognition. As distance to target increases, so must the range of effective illumination sources. Heavy, fragile, power-hungry, long-range filament bulb illuminators have been surpassed by more effective and power efficient arrays of light emitting diodes (LEDs) and now laser diodes (LDs).

While LEDs are commonly used in surveillance illuminators, and often employ some method of optical diffuser to evenly distribute light on target, an optimal solution is not as simple when using laser diode (LD) illuminators. The current method of diffusion at the macroscopic level employs an array of small refractive lenses or lens-like patterns imprinted on thin transparent plastic sheets or films. Since LEDs emit a broad range of wavelengths combined from a multiplicity of single sources into overlapping beams, their randomized light can readily be diffused by common refractive diffusers to produce a homogenized distribution.

Microdiffractive diffusers are optical elements comprising tiny lens-like surface structures measured at the nanometer scale which individually refract light in a randomized manner due to their non-periodic structures such that they collectively channel light into much smoother distributions than can be achieved with conventional lenses. The microdiffractive diffusers cause light to diverge, which smoothes and homogenizes the coherent light sources, providing uniform light without speckle or hotspots. The degree of smoothing achieved by the microdiffractive diffusers depends on the angle. For applications in which a greater degree of homogenization is required, large angle microdiffractive diffusers are utilized.

Microdiffractive diffusers can work with all types of light, but are particularly effective when a collimated light source. Color diffraction is eliminated and incoming light is channeled towards well defined areas. Microdiffractive diffusion angles are measured at FWHM and microdiffractive diffusers have an effective angular output (EAO) defined by the equation:

$$\texttt{EAO = SQRT[(light source angle)\^2+(microdiffractive diffuser angle)\^2]}.$$

When combined in the arrangement herein described, microdiffractive diffusers play an important role in the phase homogenizer of coherent light illuminators used for surveillance imaging systems.

The irradiance emitted by a laser diode (LD) is a single coherent source emitting at a much narrower wavelength band. Coherent light is susceptible to causing interference patterns when diffused or refracted which creates a speckle structure on the target which makes it more difficult to produce high quality images of illuminated objects with a surveillance video camera. Speckle noise is a field intensity pattern produced by the mutual interference of coherent beams that are subject to temporal and spatial fluctuations. To eliminate speckle noise, and to take advantage of the range boosting capabilities of laser diode based illuminators, a special means of homogenizing LD output should be employed.

Existing methods for minimizing speckle noise include use of higher energy lasers whose non-linear effects can reduce source coherence, or inserting optical delay lines in beam paths with higher delay time than the laser coherence time. Another method is time averaging of many randomized speckle-patterns of an object image, through use of rapidly movable optical elements introducing non-stationary phase modulation of a laser beam.

Short range solutions for removing LD speckle have been employed in photocopiers, digital projectors and point-of-sale barcode readers by the use of single diffusers in front of a refracting lens, rotating diffusers, and diffusers tailored for each color (projection systems). But surveillance illuminators must be capable of projecting diffused light across a wide range of distances (1 to 1000 meters and beyond) in order to create a recognizable image for camera. For this reason a speckle homogenizer employed with LD illuminators must be highly efficient at long distances.

JP 2001 100621 A discloses a device for homogenizing light and its manufacturing method. An energy efficient illumination apparatus and a method for illuminating surfaces are known from US 2010/0103676 A1. US 6,081,381 discloses an apparatus and a method for reducing spatial coherence and for improving uniformity of a light beam emitted from a coherent light source. Systems and methods for providing illumination of a specimen for inspection are known from US 2007/0052953 A1. US 2008/0079904 A1 discloses display systems with spatial light modulation.

A LD speckle homogenizer employing microdiffractive diffusion materials for long distance surveillance illuminators is needed for improved imaging outcomes. The following disclosure will describe such a solution.

BRIEF SUMMARY OF THE INVENTION

The surveillance imaging system comprising the illumination system of the present invention provides more efficient speckle homogenization of coherent light to be used in long distance surveillance illuminators, comprising a phase homogenizer with at least two microdiffractive diffusers aligned on an optical axis, which together thoroughly mix coherent light so that speckle noise has little effect on imaging of LD illuminated targets. True microdiffractive diffusers are efficient transmitters of light, but also are capable of refracting at highly selective beam angles, as well as creating asymmetric distributions. Unlike short range devices which project LD light through macroscopically diffused optics to produce images, the phase homogenizer provides microdiffractiveally diffused illumination for long distance surveillance imaging. The microdiffractive diffusers are also effective at homogenizing light from an array of coherent light emitters such as an LD array.

The invention can be summarized as a surveillance imaging system comprising a surveillance video camera and an illumination system comprising a coherent light emitter aligned with a light source raypath along an optical axis with at least two separated microdiffractive diffusers the surveillance video camera producing images of a target illuminated by the illumination system, the microdiffractive diffusers comprising holographically generated surfaces of microdiffractive structure that statistically tend to diffract light at selectable angles or distribution patterns, the microdiffractive diffusers disposed upon a substrate and separated from each other by a distance determined by wavelength phase and irradiance characteristics of the coherent light emitter and by refractive characteristics of at least two microdiffractive diffusers, followed by a homogenized exit raypath in order to produce a diffused pattern of illumination optimized for surveillance imaging of distances between 1 meter to more than 1000 meters, with a lens aligned on the optical axis and situated between a first diffuser of the at least two separated microdiffractive diffusers and a second diffuser of the at least two separated microdiffrative diffusers, the illumination system is configured such that a central portion of a diffused pattern of illumination on the target is unspeckled, in which the first microdiffractive diffuser is located proximate along the optical axis to the coherent light emitter and is smaller in diameter than the second microdiffractive diffuser that is farther from the coherent light emitter.

According to the invention, the phase homogenizer comprises at least two microdiffractive diffusers aligned on an optical axis and a lens aligned on the optical axis and situated between the two diffusers.

The microdiffractive diffusers should be separated at a distance along the raypath such that coherent light emitted along the raypath is mixed and speckle noise effect is reduced on imaging of distant targets illuminated by the coherent light.

The coherent light source can be a laser diode or an array of laser diodes.

Using more than two separated microdiffractive diffusers can also be more effective in reducing speckle effect on the target, and in increasing the effective size of the light emitter from a perspective of an illuminated observer so that the diffused pattern of illumination is of lesser areal intensity for retinal safety of illuminated target individuals.

The salutary effects are achieved if a first microdiffractive diffuser is separated from a second microdiffractive diffuser by a distance in a range from approximately 2.5 centimeters to 10 centimeters. The most legible resolutions are achieved in the 7 to 9 centimeter subrange. Beyond that range, there is additional benefit, but it diminishes and approaches full illegibility at about 40.6 centimeters. Any separation beyond the optimal range of 7 to 9 centimeters has the disadvantage of having a longer physical embodiment of the surveillance equipment.

In addition to the advantages outlined above, the use of microdiffractive diffuser with LDs can increase the effective size of the light source as seen from an illuminated observer. By decreasing laser beam areal intensity, microdiffractive diffusers prevent damage to the human retina if directly observed. This feature can prevent safety hazards to human sight when LD illuminators are used in public spaces or on unintended targets.

BRIEF DESCRIPTION OF THE DRAWINGS

Figure 1 is a side view showing the basic elements of Surveillance Illumination System including a Phase Homogenizer.

Figure 2 is a side view of a Random Source (LED) illuminating a Microdiffractive Diffuser and projecting a Homogenized distribution.

Figure 3 is a side view of a Coherent Source (LD) illuminating a Microdiffractive Diffuser and projecting a Speckled distribution.

Figure 4 is a side view of a Coherent Source (LD) illuminating a Phase Homogenizer (Lensed) and projecting a homogenized distribution.

Figure 5 is a side view of a Coherent Source (LD) illuminating a Phase Homogenizer (Lensless) and projecting a partially homogenized distribution.

Figure 6 shows the effects of different embodiments of the invention in differing quality of resolution of licence plates being surveilled..

DETAILED DESCRIPTION

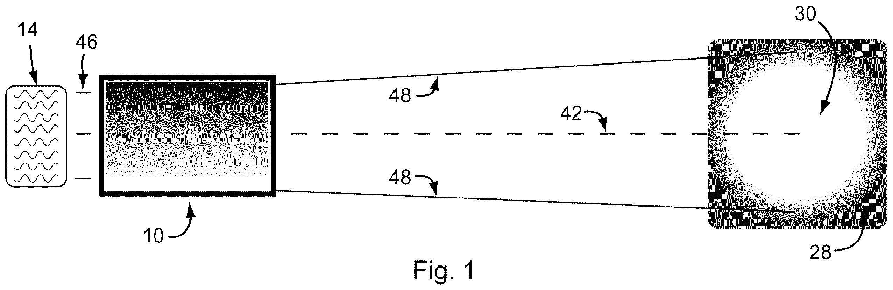

Figure 1 gives an overview of the basic elements of a surveillance illuminator employing a phase homogenizer 10. Light from a coherent source 14, a laser diode array in this example, enters the phase homogenizer 10 by means of the source ray path 46 along the optical axis 42, and exits along the homogenized ray path 48, which then illuminates the target 28 with a homogenized distribution 30.

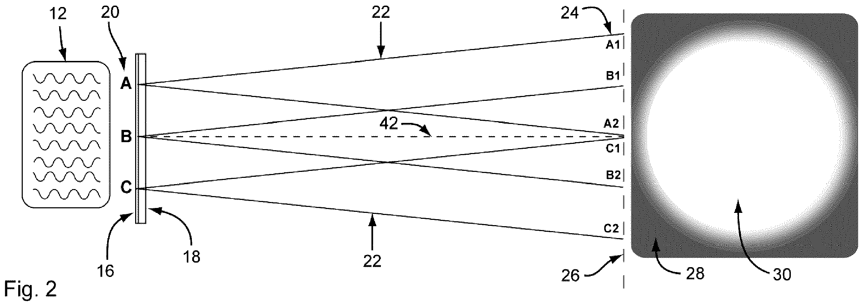

Figure 2 illustrates how light from a random source 12 such as a light emitting diode array, projects a homogenized distribution 30 on the target 28, by means of a microdiffractive diffuser 16 on a substrate 18. Illumination through source points 20 (A, B, C) is diffused along a diffusion ray path 22, to their respective diffusion points 24, (A1, A2, B1, B2, C1, C2) on the distribution plane 26.

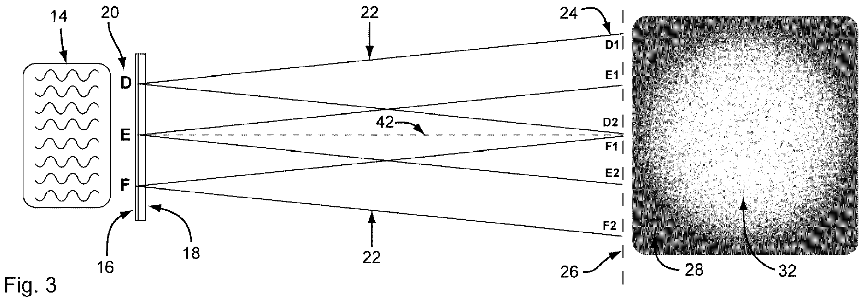

Figure 3 illustrates how light from a coherent source 14 such as a laser diode, projects a speckled distribution 32 on the target 28, by means of a microdiffractive diffuser 16 on a substrate 18. Illumination through source points 20 (D, E, F) is diffused along a diffusion ray path 22, to their respective diffusion points 24, (D1, D2, E1, E2, F1, F2) on the distribution plane 26.

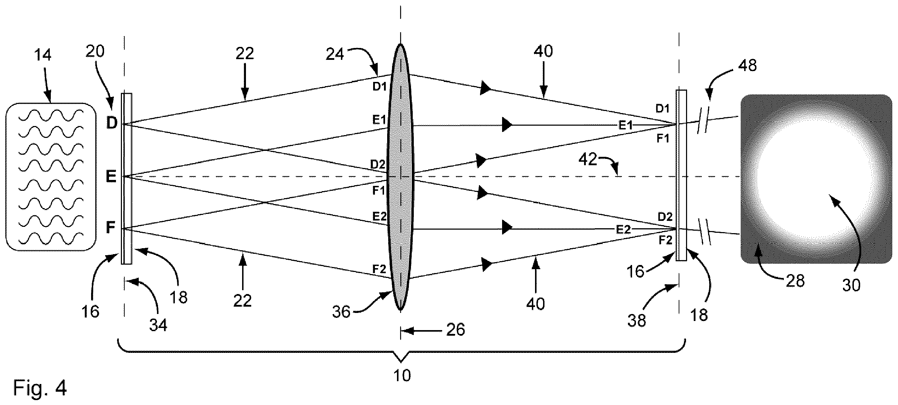

Figure 4 illustrates how light from a coherent source 14 can be made to project a homogenized distribution 30 on the target 28 by means of a microdiffractive diffuser 16 positioned at front and rear focal plane (34 & 38) of a refractive lens 36. The light diffused (22 & 24) from the source points 20 (D, E, F) at the front focal plane 34 is refracted by the lens 36 along the refracted ray path 40 to a second diffuser 16 at the rear focal plane 38. The output of the phase homogenizer 10 (lensed) follows the homogenized ray path 48 and projects a homogenized distribution 30 onto the target 28.

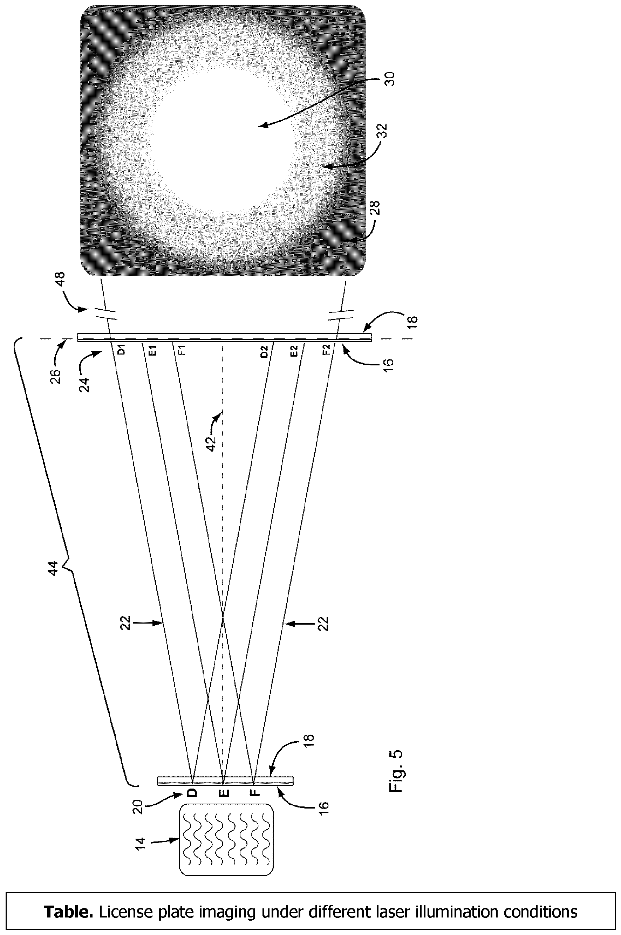

Figure 5 illustrates the lensless phase homogenizer 44 (not part of the invention). Two microdiffractive diffusers 16 are placed at an appropriate distance apart to create the diffusion ray paths 22 illustrated. The resulting distribution on the target 28 is homogenized 30 at its center and speckled 32 at its periphery.

LED arrays employ diffusers on top of beam-shaping optics and can be regarded as equivalent to an array of secondary light sources excited by a primary LED. An LED emits the combined radiation of many single-mode sources, each with very short coherence time. The resulting target 28 irradiance is an arithmetic sum of irradiances created by different parts of a microdiffractive diffuser 16. LED sources 12 generate randomized wavelengths that are seldom in phase, whereas an LD has a much longer coherence time, and so it can be put out of phase by diffraction or diffusion.

The above is illustrated in Fig. 2, where the randomized source (LED) 12, is shown emitting non-coherent light through the microdiffractive diffuser 16, which spreads the random non-coherent light across the distribution plane 26, partly mixing it further. The resultant illumination on the target 28 presents a homogenized distribution 30.

The target 28 irradiance of a coherent laser diode (LD) source 14 is defined by the vector sum of light waves sent to a target 28 by different parts of an LD or of a microdiffractive diffuser 16 inserted in its beam-path. A vector sum of light waves depends not only on irradiances created by different parts of a light source, like an arithmetic sum, but also on the phases of radiation coming from different parts of the source. Therefore, phase homogenization for a LD source 14 is a much more complicated problem than just intensity homogenization for an LED source 12.

As illustrated in Fig. 3, a coherent source (LD) 14 emits waves which are in phase with each other, then pass through the microdiffractive diffuser 16, and arrive at the same diffusion points 24 on the distribution plane 26 as does a randomized source 12. But unlike light from a non-coherent random source 12, light from a coherent source 14 constructively interferes (phases add) or destructively interferes (phases cancel) at its diffusion points 24. Depending on whether the wavelength phases of two intersecting diffusion ray paths 22 may be added together or cancel each other out, any given diffusion point 24 may present an island of double brightness or complete darkness, respectively. The speckled distribution 32 illustrated in Fig. 3 is the result of these interference patterns of diffused coherent light 14.

The following is a more detailed explanation of the nature of the speckle effect created by coherent emitters. As described by equation (1) below, a single-mode laser emits the smallest possible Entendu (product of the beam waist size $2R_0$ by its divergence $2\theta_0$ sine):

$$E_{SM} = R_0 \sin(\theta_0) = \lambda/\pi \qquad\qquad (1)$$

where $\lambda$ is the wavelength. The laws of physics forbid radiation with an Entendu smaller than that defined by equation (1). Monochromatic radiation consists of a multiplicity of single modes (speckles) so that a "snapshot" of coherent illumination looks like an aggregate of these grain-like speckles. (see Fig. 3) Generally, this effect is not apparent by observing light bulbs or LEDs because their multichromatic radiation changes every few picoseconds, so we see a homogenized illumination. However, laser radiation is coherent and a laser keeps its modal structure over time. If we look at a multi-mode LD emitting zone through a microscope, we see a series of single-mode speckles that appear similar to the straight line of "grains" observed along a p-n junction.

For the purposes of this disclosure, the term homogenization will be defined as an optical energy distribution free of speckle noise over a specifically delimited area of illumination.

A brief note on the properties of the microdiffractive diffuser used in this invention is necessary. Incorporated into the surface of a plastic-like substrate is a diffuser comprised of a holographically generated surface of microdiffractive structure that statistically tends to diffract light at a selectable angle or distribution pattern. Microdiffractive diffraction has a rough equivalence to macro-scale diffusion, but performs with greater optical efficiency and control over its light shaping properties. In addition, microdiffractive diffusers do not require precise alignment of discrete point sources to transmit maximum illuminance, as when an array of laser diodes projects a light manifold through a microdiffractive diffuser16.

The preferred embodiment of the phase homogenizer will now be described in further detail. Figure 4 illustrates the preferred embodiment of the phase homogenizer 10 which employs microdiffractive diffusers 16 positioned at the front focal plane 34 and rear focal plane 38 of a refractive lens 36. The diffusion ray paths 22 are the same as those illustrated in Figs. 2 & 3, but have been shortened in this drawing to make room for the full embodiment. Note that source points 20 (D, E, F) are representative, and that any points of illumination from the LD source 14 could be used to demonstrate how the phase homogenizer 10 removes speckle noise.

From the D source point 20 at the front focal plane 34, the diffuser 16 splits the light into a cone bounded by two diffusion ray paths 22 which enter the refractive lens 36 at the D1 & D2 diffusion points 24. Notice how the lens 36 bends the LD light along the refracted ray paths 40 to illuminate the entire inside surface of the second diffuser 16. Diffracted light from source points 20 E & F are also refracted so as to illuminate the inside surface of the second diffuser 16 positioned at the rear focal plane 38 of the lens 36. By this means each point of source light 14 is spread by the first diffuser 16, then collimated by the lens 36 onto the second diffuser 16, which then spreads it towards the target 28 via the homogenized ray path 48. The phase homogenizer 10 uses each point (D) of coherent light 14 to create a beam (D1 to D2) that shines through the second diffuser 16. Since there are theoretically an infinite number of source points 20, there are an infinite number of generated beams that wash through the second diffuser 16, and by this means coherent light 14 is randomized and diffusive speckle noise is removed.

Any coherent light 16 from any source point 20 at the front focal plane 34 is in phase, and by passing through the phase homogenizer 10, is fully randomized, and therefore projects LD illumination on target 28 that is fully homogenized as defined above.

Proven optical principles demonstrate that the optical energy distribution in a lens' rear focal plane 38 is a Fourier transform of the optical energy distribution in its front focal plane 34. Under such a transform the optical wave phase variation in the RFP 38 is proportional to the square of the ray coordinates both in the FFP 34 and RFP 38. By this means, the phase distribution of coherent light in the RFP 38 is effectively homogenized.

Other embodiments of the phase homogenizer include, but are not limited to the use of asymmetric diffusers.

Asymmetric Phase Homogenization:

Referring to Fig. 4 -- by replacing the existing microdiffractive diffuser 16 which creates symmetrical diffusion at the rear focal plane 38, with a microdiffractive diffuser 16 that creates an asymmetrical diffusion pattern, a directional distribution is possible. Directional or asymmetric diffusers have a surface comprised of a microdiffractive structure that statistically tends to refract light at a different angle in a horizontal plane than in a vertical plane. Asymmetric diffusion creates a Gaussian distribution which sends more light where it needs to be, onto targets 28 that are predominantly along the horizontal plane.

The distribution created by a lens 36 and two diffusers 16 pressed together and placed after the lens 36 is similar to the distribution created by the same lens 36 and a single diffuser 16 with doubled diffusion angle, in place of these two diffusers 16. However, when we increase the distance between two diffusers 16, homogenization increases as the distance between the diffusers 16 is increased. At some distance the majority of speckle disappears and the distribution becomes homogenized 30. A similar result can be achieved just with two diffusers 16 without a lens 36.

Lensless Phase Homogenization (not part of the invention) is shown in Fig. 5. A lensless phase homogenizer 44, is composed of two microdiffractive diffusers 16 separated by sufficient distance to project an area of homogenized distribution 30 on the target 28 centered around the optical axis 42, but which is also surrounded by a ring of speckle distribution 32. If the diffusers 16 are far enough apart, the overlapping areas of speckle admit a cone of uniform mixing around the optical axis 42, so that the interference of coherent light 14 is averaged in this region. When rays are recombining on other side of the air gap, between D and D1 for example, path lengths become mismatched and phases become randomized. The air gap randomizes the coherence, which key to homogenizing coherent light. Prior art solutions use mirrors or gratings or multiple lenses to create the equivalent to an air gap, but two diffusers can do this partially, although two diffusers surrounding a lens is the optimal solution.

Note that when microdiffractive diffusers 16 are not precisely at either focal plane of a lens 36, the method of phase homogenization is still possible, but the distribution is not as uniform. Even when the diffusers 16 are on the same side of the lens 36, or without a lens 36 at all, but separated by a distance large enough so that the light reaching the second diffuser 16, and the radiation from majority of points of the first diffuser 16 are mixed, this method still gives suitable phase homogenization.

When the effective size of the first diffuser is much smaller than the area illuminated by the light dispersed by the first diffuser, each point of the second diffuser receives radiation from each point of the first diffuser, as illustrated in Fig. 5. This is not valid only for the narrow strip at the edge of the second diffuser. So the light intensity distribution existing at the first diffuser is effectively mixed at the central area of the second diffuser. The optical wave phase at the second diffuser changes uniformly. So the phase distribution of light at the second diffuser is also effectively mixed, except at the edge of the second diffuser.

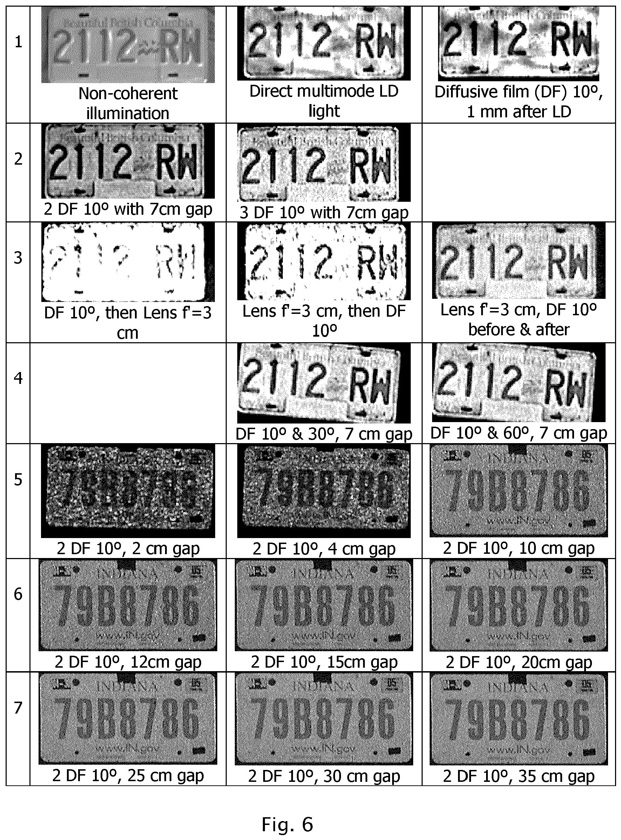

Referring to Figure 6, row 1 shows the improvement in reading the license plate alphanumers from non-coherent illumination (on the left) to direct multimode laser diode (LD) light (in the middle), and the continued improvement (on the right) upon adding a diffuser just past (1 millimeter) the laser diode. Row 2 illustrates the improvement upon using 2 diffusers (left) and 3 diffusers (right), each 10 degrees, separated by 7 centimeters, with the main license plate alphanumerics clearly visible, and even the text of the jurisdiction of the plate coming into legibility. Row 3 shows the effect of a single diffuser before the lens (left), after the lens (center), and with a diffuser before the lens and a second diffuser after (right). Row 4 shows the effect is achieved even if the second diffuser is different than the first, e.g. 10 degrees and 30 degrees (middle) and 10 degrees and 60 degrees (right). Row 5 shows the improving effect when the separation of two diffusers is increased from 2 centimeters (left) to 4 centimeters (center) to 10 centimeters (right). Row 6 shows continuing improvement at 12 centimeters of separation ("gap" in the drawing's labels), but negligible extra improvement from increasing beyond that to 15 centimeters (center) or 20 centimeters (right). There is essentially no improvement in resolution from additionally increasing the gap further, as shown in Row 7, to 25, 30, or 35 centimeters.

The use of two separated diffusers in sequence introduces a new system quality not achievable with a single diffuser. It allows suppressing the FOI non-uniformity caused by light diffraction on microdiffractive diffusers 16 and by a laser modal structure. The method of homogenizing speckle by two separated microdiffractive diffusers 16 does not fall into the categories of eliminating speckle noise described elsewhere. The illuminance distribution created by a laser depends both on intensity and phase of all radiation parts, coming to a particular target point from different points of primary (laser itself) or secondary (diffuser surface) light sources.

Other embodiments are not ruled out or similar methods leading to the same result.

For applications requiring moderate homogenization an LD can be used with a simplest optical beam shaping system comprising just two microdiffractive diffusers separated by a a distance determined by the wavelength phase and irradiance characteristics of the LD and by the refractive characteristics of the microdiffractive diffusers, without a lens. This is possible with the use of low divergence laser beams. FOI of such a system is a square root of sum of squares of diffusive angles of both diffusers.

For narrower FOI a simplest lens should be added and two small angle microdiffractive diffusers should be placed near its front and rear focal planes, with the LD manifold placed close to the first microdiffractive diffuser. In this case the FOI is defined by the diffusion angle of a second diffuser only, which can be different in vertical and horizontal planes to match the field of view of a camera used with the illuminator.

Another embodiment includes the use of multiple element objectives (multiple lens combinations) in place of a single refractive lens between microdiffractive diffusers. The diffusers would be located at the front and rear focal planes of the resultant of the combined lenses. One application of the use of a multiple element objective would be to create a variable beam pattern with all the described properties of the preferred embodiment by moving the elements in the objective.

Other advantages of using the novel device over other methods or devices is described herein. A phase homogenizer is primarily used for enhancing surveillance illumination for improved imaging. Other uses may include, but are not limited to the use of this invention in displays and light screens, projection systems, flat panel TVs, computer monitors, palm-held displays, barcode scanning, flashlights, lamps, microscope, fiber-optics, and LED illumination, laser, LD and CCFL homogeneity and beam shapers, optical sensing, bio-medical instrumentation, architectural, office and in-house lighting, automotive lighting, signs, posters and cell phone displays.

The foregoing description of the preferred apparatus and method of installation should be considered as illustrative only, and not limiting. Other forming techniques and other materials may be employed towards similar ends. Various changes and modifications will occur to those skilled in the art, without departing from the true scope of the invention as defined in the above disclosure, and the following general claims.

**Claims**

1. A surveillance imaging system comprising a surveillance video camera and an illumination system comprising a coherent light emitter (14) aligned with a light source raypath (46) along an optical axis (42) with at least two separated microdiffractive diffusers (16), the surveillance video camera producing images of a target (28) illuminated by the illumination system, the microdiffractive diffusers (16) comprising holographically generated surfaces of microdiffractive structure that statistically tend to diffract light at selectable angles or distribution patterns, the microdiffractive diffusers (16) disposed upon a substrate (18) and separated from each other by a distance determined by wavelength phase and irradiance characteristics of the coherent light emitter and by refractive characteristics of at least two microdiffractive diffusers (16), followed by a homogenized exit raypath (48) in order to produce a diffused pattern of illumination optimized for surveillance imaging of distances between 1 meter to more than 1000 meters, with a lens (36) aligned on the optical axis (42) and situated between a first diffuser of the at least two separated microdiffractive diffusers (16) and a second diffuser of the at least two separated microdiffrative diffusers (16), the illumination system is configured such that a central portion of a diffused pattern of illumination on the target (28) is unspeckled, in which the first microdiffractive diffuser (16) is located proximate along the optical axis (42) to the coherent light emitter (14) and is smaller in diameter than the second microdiffractive diffuser (16) that is farther from the coherent light emitter (14).

2. The illumination system of Claim 1, in which the microdiffractive diffusers are separated at a distance along the raypath such that coherent light emitted along the raypath is mixed and speckle noise effect is reduced on imaging of distant targets (28) illuminated by the coherent light.

3. The illumination system of Claim 1, in which the coherent light emitter comprises at least one laser diode.

4. The illumination system of claim 1, in which the coherent light emitter comprises a laser diode array.

5. The illumination system of claim 1, in which the illumination system is configured such that an aspect ratio of a diffused pattern of illumination is larger in a horizontal aspect than in a vertical aspect.

6. The illumination system of claim 1, in which multiple microdiffractive diffusers are inserted and separated in the raypath such that the effective size of the light emitter from a perspective of an illuminated observer is increased and a diffused pattern of illumination is of lesser areal intensity.

7. The illumination system of claim 1, in which the microdiffractive diffusers (16) are incorporated into the surface of the substrate (18).

8. The illumination system of claim 1, in which two microdiffractive diffusers (16) are positioned to form at least two focal planes (34, 38), namely a front focal plane (34) and a rear focal plane (38), on either side of at least one optical element, both the front focal plane (34) and the rear focal planes (38) being perpendicular to the optical axis (42).

9. The illumination system of claim 1, in which the first microdiffractive diffuser (16) is separated from the second microdiffractive diffuser (16) by a distance in a range from 4 centimeters to 35 centimeters.

10. The illumination system of Claim 1, in which:

   a) the microdiffractive diffusers (16) are separated at a distance along the raypath such that coherent light emitted along the raypath is mixed and speckle noise effect is reduced on imaging of distant targets (28) illuminated by the coherent light;
   b) the coherent light emitter comprises a laser diode array;
   c) an aspect ratio of a diffused pattern of illumination is larger in a horizontal aspect than in a vertical aspect;
   d) multiple microdiffractive diffusers (16) are inserted and separated in the raypath such that the effective size of the light emitter from a perspective of an illuminated observer is increased and a diffused pattern of illumination is of lesser areal intensity.

e) the microdiffractive diffusers (16) are positioned to form at least two focal planes (34, 38), namely a front focal plane (34) and a rear focal plane (38), on either side of at least one optical element, both the front focal plane (34) and the rear focal planes (38) being perpendicular to the optical axis (42);

f) the first microdiffractive diffuser (16) is separated from the second microdiffractive diffuser (16) by a distance in a range from 10 to 15 centimeters.

**Patentansprüche**

1. Überwachungssystem mit Bildgebung, aufweisend eine Überwachungsvideokamera und ein Beleuchtungssystem, das einen entlang einem Lichtquellenstrahlengang (46) einer optischen Achse (42) ausgerichteten kohärenten Lichtemitter (14) mit mindestens zwei beabstandeten mikrodiffraktiven Diffusoren (16) aufweist, wobei die Überwachungsvideokamera Bilder eines durch das Beleuchtungssystem beleuchteten Ziels (28) erzeugt, wobei die mikrodiffraktiven Diffusoren (16) holographisch erzeugte Flächen einer mikrodiffraktiven Struktur aufweisen, die statistisch dazu tendieren, Licht unter auswählbaren Winkeln oder Verteilungsmustern zu beugen, wobei die mikrodiffraktiven Diffusoren (16) auf einem Substrat (18) angeordnet sind und um einen Abstand voneinander beabstandet sind, der durch Wellenlängenphasen- und Bestrahlungseigenschaften des kohärenten Lichtemitters und durch die Brechungseigenschaften von mindestens zwei mikrodiffraktiven Diffusoren (16) bestimmt ist, gefolgt von einem homogenisierten Austrittsstrahlengang (48), um ein diffuses Beleuchtungsmuster zu erzeugen, das für die Überwachung mit Bildgebung von Abständen zwischen 1 Meter und mehr als 1000 Metern optimiert ist, mit einer Linse (36), die auf der optischen Achse (42) ausgerichtet ist und zwischen einem ersten Diffusor der mindestens zwei beabstandeten mikrodiffraktiven Diffusoren (16) und einem zweiten Diffusor der mindestens zwei beabstandeten mikrodeffrativen Diffusoren (16) gelegen ist, wobei das Beleuchtungssystem so konfiguriert ist, dass ein zentraler Abschnitt eines diffusen Beleuchtungsmusters auf dem Ziel (28) nicht granuliert ist, bei dem der erste mikrodiffraktive Diffusor (16) nahe der optischen Achse (42) zu dem kohärenten Lichtemitter (14) befindlich ist und einen kleineren Durchmesser als der zweite mikrodiffraktive Diffusor (16) hat, der weiter von dem kohärenten Lichtemitter (14) entfernt ist.

2. Beleuchtungssystem nach Anspruch 1, bei dem die mikrodiffraktiven Diffusoren in einem Abstand entlang des Strahlenpfads voneinander beabstandet sind, so dass kohärentes Licht, das entlang des Strahlenpfads emittiert wird, gemischt wird und ein Speckle-Rauscheffekt bei der Bildgebung entfernter Ziele (28), die von dem kohärenten Licht beleuchtet werden, verringert wird.

3. Beleuchtungssystem nach Anspruch 1, bei dem der kohärente Lichtemitter mindestens eine Laserdiode aufweist.

4. Beleuchtungssystem nach Anspruch 1, bei dem der kohärente Lichtemitter eine Laserdiodenanordnung aufweist.

5. Beleuchtungssystem nach Anspruch 1, bei dem das Beleuchtungssystem so konfiguriert ist, dass ein Aspektverhältnis eines diffusen Beleuchtungsmusters in einem horizontalen Aspekt größer ist als in einem vertikalen Aspekt.

6. Beleuchtungssystem nach Anspruch 1, bei dem mehrere mikrodiffraktive Diffusoren in den Strahlengang eingefügt und voneinander beabstandet sind, so dass die effektive Größe des Lichtemitters aus einer Perspektive eines beleuchteten Beobachters erhöht wird und ein diffuses Beleuchtungsmuster eine geringere Flächenintensität aufweist.

7. Beleuchtungssystem nach Anspruch 1, bei dem die mikrodiffraktiven Diffusoren (16) in die Oberfläche des Substrats (18) integriert sind.

8. Beleuchtungssystem nach Anspruch 1, bei dem zwei mikrodiffraktive Diffusoren (16) positioniert sind, um mindestens zwei Brennebenen (34, 38), nämlich eine vordere Brennebene (34) und eine hintere Brennebene (38) auf beiden Seiten mindestens eines optischen Elements zu bilden, wobei sowohl die vordere Brennebene (34) als auch die hintere Brennebene (38) senkrecht zur optischen Achse (42) liegen.

9. Beleuchtungssystem nach Anspruch 1, bei dem der erste mikrodiffraktive Diffusor (16) von dem zweiten mikrodiffraktiven Diffusor (16) um einen Abstand in einem Bereich von 4 cm bis 35 cm beabstandet ist.

10. Beleuchtungssystem nach Anspruch 1, bei dem:

a) die mikrodiffraktiven Diffusoren (16) in einem Abstand entlang des Strahlenpfads voneinander beabstandet sind, so dass kohärentes Licht, das entlang des Strahlenpfads emittiert wird, gemischt wird und der Speckle-Rauscheffekt bei der Bildgebung entfernter Ziele (28), die durch das kohärente Licht beleuchtet werden, verringert wird;

b) der kohärente Lichtemitter eine Laserdiodenanordnung aufweist;

c) ein Aspektverhältnis eines diffusen Beleuchtungsmusters in einem horizontalen Aspekt größer als in einem vertikalen Aspekt ist;

d) mehrere mikrodiffraktive Diffusoren (16) in den Strahlengang eingefügt und beabstandet sind, so dass die effektive Größe des Lichtemitters aus Sicht eines beleuchteten Beobachters erhöht wird und ein diffuses Beleuchtungsmuster eine geringere Flächenintensität aufweist;

e) die mikrodiffraktiven Diffusoren (16) so positioniert sind, dass sie mindestens zwei Brennebenen (34, 38) bilden, nämlich eine vordere Brennebene (34) und eine hintere Brennebene (38) auf jeder Seite mindestens eines optischen Elements, wobei sowohl die vordere Brennebene (34) als auch die hintere Brennebene (38) senkrecht zur optischen Achse (42) liegen;

f) der erste mikrodiffraktive Diffusor (16) vom zweiten mikrodiffraktiven Diffusor (16) um einen Abstand in einem Bereich von 10 bis 15 cm beabstandet ist.

## Revendications

1. Système d'imagerie de surveillance comprenant une caméra vidéo de surveillance et un système d'éclairage comprenant un émetteur de lumière cohérente (14) aligné avec un trajet des rayons (46) de la source de lumière le long d'un axe optique (42) avec au moins deux diffuseurs microdiffractifs séparés (16), la caméra vidéo de surveillance produisant des images d'une cible (28) éclairée par le système d'éclairage, les diffuseurs microdiffractifs (16) comprenant des surfaces de structure microdiffractive générées par holographie qui tendent statistiquement à diffracter la lumière à des angles ou selon des motifs de distribution sélectionnables, les diffuseurs microdiffractifs (16) disposés sur un substrat (18) et séparés les uns des autres par une distance déterminée par des caractéristiques de phase de longueur d'onde et d'irradiance de l'émetteur de lumière cohérente et par des caractéristiques réfractives d'au moins deux diffuseurs microdiffractifs (16), suivis par un trajet des rayons de sortie homogénéisé (48) afin de produire un motif d'éclairage diffusé optimisé pour l'imagerie de surveillance de distances comprises entre 1 mètre et plus de 1000 mètres, avec une lentille (36) alignée sur l'axe optique (42) et située entre un premier diffuseur des au moins deux diffuseurs microdiffractifs séparés (16) et un deuxième diffuseur des au moins deux diffuseurs microdiffractifs séparés (16), le système d'éclairage est configuré de telle sorte qu'une partie centrale d'un motif d'éclairage diffusé sur la cible (28) n'est pas tavelé, le premier diffuseur microdiffractif (16) étant situé à proximité le long de l'axe optique (42) de l'émetteur de lumière cohérente (14) et ayant un plus petit diamètre que le deuxième diffuseur microdiffractif (16) qui est plus éloigné de l'émetteur de lumière cohérente (14).

2. Système d'éclairage de la revendication 1, dans lequel les diffuseurs microdiffractifs sont séparés par une distance telle le long du trajet des rayons que la lumière cohérente émise le long du trajet des rayons est mélangée et un effet de bruit de tavelure est réduit sur l'imagerie de cibles distantes (28) éclairées par la lumière cohérente.

3. Système d'éclairage de la revendication 1, dans lequel l'émetteur de lumière cohérente comprend au moins une diode laser.

4. Système d'éclairage de la revendication 1, dans lequel l'émetteur de lumière cohérente comprend un réseau de diodes laser.

5. Système d'éclairage de la revendication 1, le système d'éclairage étant configuré de telle sorte qu'un rapport de forme d'un motif d'éclairage diffusé est plus grand dans un sens horizontal que dans un sens vertical.

6. Système d'éclairage de la revendication 1, dans lequel de multiples diffuseurs microdiffractifs sont insérés et séparés sur le trajet des rayons de telle sorte que la taille effective de l'émetteur de lumière dans une perspective d'un observateur éclairé est accrue et un motif d'éclairage diffusé est de moindre intensité surfacique.

7. Système d'éclairage de la revendication 1, dans lequel les diffuseurs microdiffractifs (16) sont incorporés dans la surface du substrat (18).

8. Système d'éclairage de la revendication 1, dans lequel deux diffuseurs microdiffractifs (16) sont positionnés pour former au moins deux plans focaux (34, 38), à savoir un plan focal avant (34) et un plan focal arrière (38), sur chaque côté d'au moins un élément optique, le plan focal avant (34) et le plan focal arrière (38) étant tous deux perpendiculaires à l'axe optique (42).

9. Système d'éclairage de la revendication 1, dans lequel le premier diffuseur microdiffractif (16) est séparé du deuxième diffuseur microdiffractif (16) par une distance dans une gamme de 4 centimètres à 35 centimètres.

10. Système d'éclairage de la revendication 1, dans lequel :

a) les diffuseurs microdiffractifs (16) sont séparés par une distance telle le long du trajet des rayons que la lumière cohérente émise le long du trajet des rayons est mélangée et un effet de bruit de tavelure est réduit sur l'imagerie de cibles distantes (28) éclairées par la lumière cohérente ;
b) l'émetteur de lumière cohérente comprend un réseau de diodes laser ;
c) un rapport de forme d'un motif d'éclairage diffusé est plus grand dans un sens horizontal que dans un sens vertical ;
d) de multiples diffuseurs microdiffractifs (16) sont insérés et séparés sur le trajet des rayons de telle sorte que la taille effective de l'émetteur de lumière dans une perspective d'un observateur éclairé est accrue et un motif d'éclairage diffusé est de moindre intensité surfacique ;
e) les diffuseurs microdiffractifs (16) sont positionnés pour former au moins deux plans focaux (34, 38), à savoir un plan focal avant (34) et un plan focal arrière (38), sur chaque côté d'au moins un élément optique, le plan focal avant (34) et le plan focal arrière (38) étant tous deux perpendiculaires à l'axe optique (42) ;
f) le premier diffuseur microdiffractif (16) est séparé du deuxième diffuseur microdiffractif (16) par une distance dans une gamme de 10 à 15 centimètres.

Fig. 1

EP 2 929 235 B1

Fig. 2

Fig. 3

Fig. 4

14

Fig. 5

**Table.** License plate imaging under different laser illumination conditions

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001100621 A
- US 20100103676 A1
- US 6081381 A
- US 20070052953 A1
- US 20080079904 A1